# EUROPEAN PATENT APPLICATION

(11) **EP 2 728 631 A1**
(43) Date of publication of application: **07.05.2014**
(21) Application number: 13275278.3
(22) Date of filing: 04.11.2013
(51) Int. Cl.: H01L 33/38, H01L 33/62, H01L 33/40, H01L 33/64

(54) **Semiconductor light emitting diode including thermally conductive substrate**

(30) Priority: 05.11.2012 KR 20120124027
(71) Applicant: Iljin Led Co., Ltd., Ansan-si, Gyeonggi-do 425-090 (KR)
(72) Inventor: Song, Jung-Sub, 306-805 Daejeon (KR); Kim, Dong-Woo, 135-794 Seoul (KR); Hwang, Seong-Joo, 135-794 Seoul (KR); Kim, Seung-Yong, 442-853 Gyeonggi-do (KR)
(74) Representative: Strachan, Victoria Jane

(57) **Abstract**

The present disclosure provides a novel semiconductor light emitting diode which has excellent current spreading capabilities and allows efficient heat discharge through a lower substrate having excellent thermal conductivity. The semiconductor light emitting diode enables uniform distribution of current flowing through semiconductor layers while minimizing loss of an active layer due to mesa etching and the like, thereby increasing an effective light emitting area. In addition, the semiconductor light emitting diode is provided at a lower side thereof with a substrate having excellent thermal conductivity and thus efficiently dissipates heat generated from the semiconductor layers therethrough, thereby improving durability of the light emitting diode.

## Description

### BACKGROUND

### 1. Technical Field

The present invention relates to a semiconductor light emitting diode which has excellent current spreading capabilities and allows efficient heat discharge through a lower substrate having excellent thermal conductivity.

### 2. Description of the Related Art

Conventional semiconductor devices include, for example, GaN-based nitride semiconductor devices, which are applied to light emitting diodes, such as blue or green LEDs, and high-speed switching and high-power devices, such as MESFETs, HEMTs, and the like.

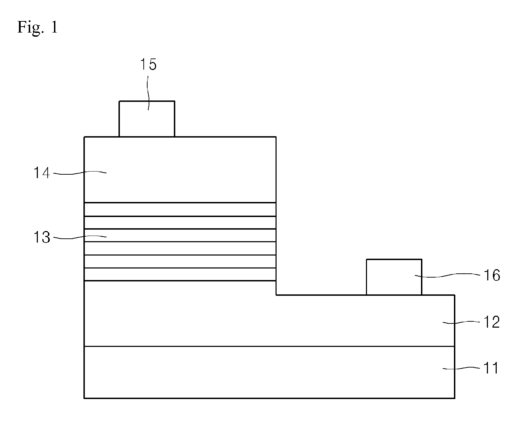

Fig. 1 is a sectional view of a typical semiconductor light emitting diode.

Referring to Fig. 1, the semiconductor light emitting diode is formed on a growth substrate 11. More particularly, a nitride light emitting diode includes an n-type nitride semiconductor layer 12, an active layer 13, and a p-type nitride semiconductor layer 14.

In addition, an n-side electrode pad 15 is formed to be electrically connected to the n-type nitride semiconductor layer 12 so as to inject electrons into the n-type nitride semiconductor layer 12. Further, a p-side electrode pad 16 is formed to be electrically connected to the p-type nitride semiconductor layer 14 so as to inject holes into the p-type nitride semiconductor layer 14.

However, high resistivity of the p-type nitride semiconductor layer does not allow uniform current spreading within the p-type nitride semiconductor layer, causing concentration of electric current at a region wherein the p-side electrode pad is formed. Further, electric current flows into the n-side electrode pad through the semiconductor layers. Accordingly, current is concentrated in the region of the n-type nitride semiconductor layer where the n-side electrode pad is formed, causing concentrated current flow through a corner of the light emitting diode. Such concentration of electric current causes reduction in light emitting area, thereby deteriorating luminous efficacy.

In order to obtain high power, for example, for light emitting diodes for lighting, the light emitting diodes have been increasingly scaled up beyond about 1 mm². However, as the areas of the light emitting diodes increase, it becomes more difficult to achieve uniform current distribution. Accordingly, improving surface spreading efficiency over large surface areas is now recognized as a major technical challenge.

Most past studies have focused upon improving various forms and arrangements of p-side electrodes and n-side electrodes. For example, US Patent No. 6,486,499 discloses an electrode structure including a plurality of electrode fingers in which n-side electrodes and p-side electrodes extend to be separated a constant distance from each other and are engaged with each other. This electrode structure is designed to provide an additional current path, securing a large effective light emitting area, and ensuring uniform current flow.

However, such an electrode structure also has problems in that output efficiency is deteriorated and current spreading efficiency is limited, as current density is increased in a p-type nitride layer near the p-side electrode.

A typical nitride semiconductor device is grown on a sapphire substrate. However, since sapphire has a relatively low thermal conductivity, the sapphire substrate is limited in terms of improvement in optical output properties. In addition, since high power of a semiconductor light emitting diode requires application of high current, it is also important to solve a heat discharge problem of the semiconductor light emitting diode.

Therefore, there is a need for a semiconductor light emitting diode, which enables uniform distribution of current flowing through semiconductor layers while allowing efficient discharge of heat, thereby improving luminous efficacy.

### BRIEF SUMMARY

The inventors of the present invention have conducted intensive studies to solve such problems, and found that, when a semiconductor light emitting diode includes a substrate, a bonding metal layer, an exposing portion through which a first semiconductor layer is exposed, a reflective metal layer formed in contact with a second semiconductor layer, and first and second electrode pads formed outside a light emitting face above the substrate such that the first semiconductor layer exposed through the exposing portion is electrically connected to the reflective metal layer via spreading metal layers, and the spreading metal layers are electrically isolated from an active layer, the second semiconductor layer, and the reflective metal layer, the semiconductor light emitting diode efficiently dissipates heat through a lower substrate while maximizing current spreading, thereby providing enhanced brightness.

Therefore, the present invention is aimed at providing a novel semiconductor light emitting diode which has excellent current spreading capabilities and efficiently dissipates heat.

In accordance with one aspect of the present invention, a semiconductor light emitting diode includes: a substrate; a bonding metal layer; a first spreading metal layer; a second spreading metal layer; a reflective metal layer; an insulating layer isolating the first spreading metal layer from the second spreading metal layer; a stack structure of a second semiconductor layer, an active layer and a first semiconductor layer, the stack structure being partially placed on the reflective metal layer; and first and second electrode pads formed in regions not overlapping the first semiconductor layer, the active layer, and the second semiconductor layer in a vertical direction.

More specifically, the light emitting diode includes: a first semiconductor layer; an active layer; a second semiconductor layer; a substrate; a bonding metal layer placed between the substrate and the second semiconductor layer; a plurality of exposing portions formed by partially removing the second semiconductor layer and the active layer such that the first semiconductor layer is exposed therethrough; a reflective metal layer formed in contact with the second semiconductor layer; first and second electrode pads formed outside a light emitting face above the substrate; a first spreading metal layer electrically connected to the exposing portions and the first electrode pad and formed on a rear side of the light emitting face; a second spreading metal layer electrically connected to the reflective metal layer and the second electrode pad and formed on the rear side of the light emitting face; and a first insulating layer forming a stack structure together with a portion of the first spreading metal layer or the second spreading metal layer, and electrically insulating the first spreading metal later from the active layer, the second semiconductor layer, the reflective metal layer and the second spreading metal layer.

The semiconductor light emitting diode according to the present invention enables uniform distribution of current flowing through semiconductor layers while minimizing loss of an active layer due to mesa etching and the like, thereby increasing an effective light emitting area.

In addition, the semiconductor light emitting diode according to the present invention is provided at a lower side thereof with a substrate having excellent thermal conductivity and thus efficiently dissipates heat generated from the semiconductor layers through the substrate, thereby improving durability of the light emitting diode.

### BRIEF DESCRIPTION OF THE DRAWINGS

The above and other aspects, features, and advantages of the invention will become apparent from the detailed description of the following embodiments in conjunction with the accompanying drawings, in which:
Fig. 1 is a sectional view of a general semiconductor light emitting diode;
Fig. 2 is a plan view of a semiconductor light emitting diode according to one embodiment of the present invention;
Fig. 3 is a cross-sectional view taken along line A-A of Fig. 2; and
Fig. 4 is a cross-sectional view taken along line B-B of Fig. 2.

### DETAILED DESCRIPTION

Exemplary embodiments of the present invention will now be described in detail with reference to the accompanying drawings. It should be understood that the present invention is not limited to the following embodiments and may be embodied in different ways, and that the embodiments are given to provide complete disclosure of the invention and to provide thorough understanding of the invention to those skilled in the art. The scope of the invention is limited only by the accompanying claims and equivalents thereof. Like components will be denoted by like reference numerals throughout the specification.

In the drawings, the thicknesses of layers and regions are exaggerated or omitted for convenience of description. It will be understood that when an element such as a layer, film, region or substrate is referred to as being placed "on" another element, it can be directly placed on the other element, or an intervening layer(s) may also be present. In addition, when an element is referred to as being placed "under" or "below" another element, it can be directly placed under or below the other element, or an intervening layer(s) may be present. On the other hand, when an element is referred to as being directly placed "on" or "under" another element, an intervening layer(s) is not present.

In the following embodiments, a first semiconductor layer, a second semiconductor layer, a first spreading metal layer, a second spreading metal layer, a first electrode pad, and a second electrode pad refer to an n-type nitride layer, a p-type nitride layer, an n-side spreading metal layer, a p-side spreading metal layer, an n-side electrode pad, and a p-side electrode pad, respectively.

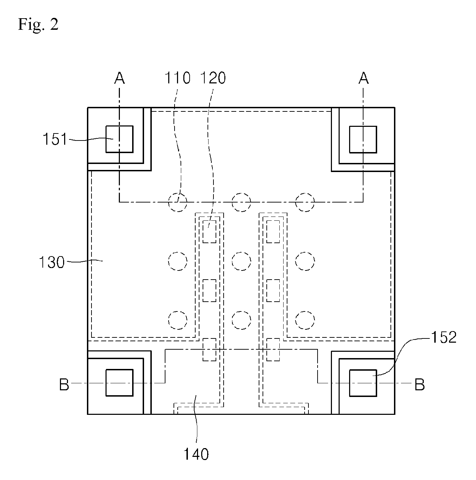

Fig. 2 is a plan view of a nitride semiconductor light emitting diode according to one embodiment of the present invention.

Referring to Fig. 2, a nitride semiconductor light emitting diode 100 according to this embodiment includes an n-type nitride layer of a convex-concave structure exposed on an upper surface thereof. In plan view, sections represented by dotted lines indicate locations of a plurality of exposing portions 110, reflective metal layer connecting regions 120 through which a reflective metal layer or a barrier metal layer is exposed downwards, an n-side spreading metal area 130, and a p-side spreading metal layer 140. In addition, an n-side pad metal 151 and a p-side pad metal 152 are placed at corners of the diode to be exposed outside a light emitting face.

As shown in Fig. 2, the exposing portions 110 may be arranged in a regular matrix, and the metal layer connecting regions 120 may be linearly arranged between rows of the exposing portions. The n-side spreading metal layer 130 connects the plurality of exposing portions 110 to each other, and the p-side spreading metal layer 140 connects the reflective metal layer connecting regions 120 to each other such that reflective metal layers can be electrically connected to each other.

In addition, as shown in Fig. 2, the exposing portions 110 may have a circular cross-section. However, it should be understood that the present invention is not limited thereto, and the exposing portions may have a triangular cross-section, a rectangular cross-section, or other polygonal cross-sections. The exposing portions 110 may have a diameter ranging from 1 µm to 200 µm, specifically 5 µm to 150 µm. In addition, the plural exposing portions may have the same size or different sizes.

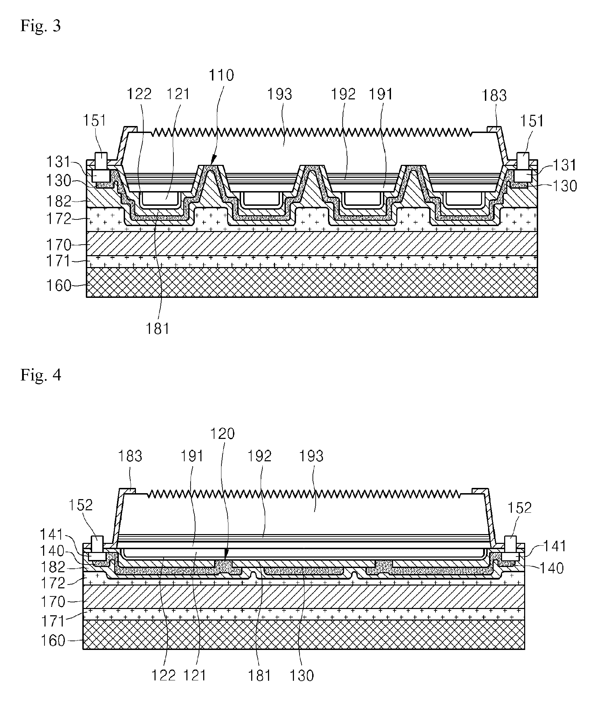

Figs. 3 and 4 are sectional views taken along section lines A-A and B-B of Fig. 2, respectively, illustrating a specific configuration of the nitride light emitting diode.

Fig 3 is a sectional view taken along line A-A, showing electrical connection between the n-side spreading metal layer and the exposing portions. Referring to Fig. 3, the nitride semiconductor light emitting diode includes, from bottom to top, a lower substrate 160, a first junction metal layer 171, a bonding metal layer 170, a second junction metal layer 172, a second insulating layer 182, an n-side spreading metal layer 130, a first insulating layer 181, a barrier metal layer 122, a reflective metal layer 121, a p-type nitride layer 191, an active layer 192, and an n-type nitride layer 193. In addition, the diode includes, outside a light emitting face, an n-side electrode pad 131 electrically connected to the n-side spreading metal layer 130, a third insulating layer 183 placed above the n-side electrode pad 131, and an n-side pad metal 151 electrically connected to the n-side electrode pad 131 through the third insulating layer 183.

Since the n-side electrode pad 131 is formed at each corner of the light emitting diode, as shown in Fig. 2, the n-side electrode pad is placed in a region not overlapping the p-type nitride layer 191, the active layer 192, and the n-type nitride layer 193 in a vertical direction.

The lower substrate 160 may be an electrically insulating or thermally conductive substrate exhibiting excellent thermal conductivity. More specifically, the lower substrate 160 may be formed in a mono-layer or multilayer structure of at least one compound selected from among AlN, SiₓN_{y}, SiC, Si, GaAs, GaP, InP, ZnSe, ZnS, Al₂O₃, BeO, ZnO, CuW, CuMo, AlSiC, W, Mo, diamond, and metal silicide.

The lower substrate 160 is bonded onto the second insulating layer 182 via the bonding metal layer 170.

The bonding metal layer 170 may be formed of at least one metal selected from among Au, Ti, Cr, AuSn, InSn, AgSn, AuGe, InAu, NiSn, AuZn, AgZn, and AgIn.

The junction metal layers 171, 172 are formed on one or both sides of the bonding metal layer 170 to join the bonding metal layer 170 to the second insulating layer 182 and to the lower substrate 160. The junction metal layers may be formed of a metal, such as Ti, Cr, Ni, W, Pt, Pd, Ir, Zr, Au, and the like.

The n-type nitride layer 193 is brought into contact with the n-side spreading metal layer 130 through the exposing portions 110 formed upwards by etching the p-type nitride layer 191 and the active layer 192. In a region where the exposing portion 110 is not formed, a stack structure of the p-type nitride layer 191, the active layer 192, and the n-type nitride layer 193 is maintained, and the reflective metal layer 121 is formed to contact the bottom of the p-type nitride layer 191. In addition, the barrier metal layer 122 may be additionally formed to surround and protect the reflective metal layer 121 excluding an upper side of the reflective metal layer 121 adjoining the p-type nitride layer 191.

The reflective metal layer 121 may be formed of at least one metal selected from among Ag, Ni, Al, Rh, Pd, Ir, Ru, Mg, Zn, Pt, and Au. The barrier metal layer 122 may be formed of at least one metal selected from among Ti, Cr, Ni, Pt, W, Ir, and Pd.

The n-side spreading metal layer 130 formed on a rear side of the light emitting face is electrically connected to the n-type nitride layer 193 exposed through the exposing portions 110 formed upwards, and is also electrically connected to the n-side electrode pad 131. Here, the light emitting face refers to a region through which light generated in the active layer 192 is emitted upwards.

The n-side spreading metal layer 130 is electrically isolated from the active layer 192, the p-type nitride layer 191, and the reflective metal layer 121 by the first insulating layer 181. In particular, the first insulating layer 181 serves as an etching stopper to protect the electrode pad, when the n-type nitride layer is etched to expose the n-side electrode pad 131.

The bonding metal layer 170 or, in the case where the junction metal layer 172 is formed on the bonding metal layer 170, the junction metal layer 172 is electrically isolated from the n-side spreading metal layer 130 by the second insulating layer 182. To this end, the second insulating layer 182 is placed directly under the first spreading metal layer 130. The spreading metal layer may be formed of metal, alloys or any other materials allowing electrical connection.

As a result, the first insulating layer 181 and the second insulating layer 182 form a stack structure together with a portion of the n-side spreading metal layer 130.

Above the n-side electrode pad 131, the light emitting diode may include the third insulating layer 183 and the n-side pad metal 151 electrically connected to the n-side electrode pad 131 through the third insulating layer 183.

The insulating layers may be formed of silicon oxide or silicon nitride by plasma enhanced chemical vapor deposition (PECVD), sputtering, metal organic chemical vapor deposition (MOCVD), or electron beam evaporation.

The exposing portions 110 may be formed through a photoresist and the like. In the case of using a photoresist as a pattern mask, the exposing portions may be formed by photolithography, electron-beam lithography, ion-beam lithography, extreme ultraviolet lithography, proximity x-ray lithography, or nano imprint lithography, together with dry or wet etching.

The light emitting diode may further include an n-contact layer directly under the n-type nitride layer 193 exposed through the exposing portions 110. The n-contact layer is in ohmic contact with the n-type nitride to lower contact resistance. The n-contact layer may be formed of a transparent conductive oxide including In, Sn, Al, Zn, Ga, or the like. For example, the n-contact layer may be formed of anyone of ITO, CIO, ZnO, NiO, and In₂O₃.

The n-type nitride layer 193 is formed at the uppermost side of the light emitting diode, and is made of an n-type dopant-doped nitride. The n-type dopant may include Si, Ge, Sn, and the like. Here, the n-type nitride layer may have a stack structure wherein first layers and second layers are alternately stacked one above another. The first layer is formed of Si-doped n-type AlGaN or undoped AlGaN, and the second layer is formed of undoped or Si-doped n-type GaN. It should be understood that, although the n-type nitride layer may be formed as a monolayer of n-type nitride, the stack structure of the first and second layers can act as a crack-free carrier-limiting layer having good crystallinity. The light emitting face placed on the upper surface of the n-type nitride layer may have a convex-concave structure to enhance light extraction efficiency.

On a region of the light emitting face on which the concavo-convex structure is not formed, the third insulating layer deposited before forming the convex-concave structure remains instead of being removed by etching.

The active layer 192 may be formed in a single quantum well structure or multi-quantum well structure between the n-type nitride layer 193 and the p-type nitride layer 191, and may generate light by recombination of electrons flowing through the n-type nitride layer 193 and holes flowing through the p-type nitride layer 191. In this embodiment, the active layer has a multi-quantum well structure in which quantum barrier layers and quantum well layers are alternately stacked one above another and are formed of AlₓGa_{y}In_{z}N (where x+y+z=1, 0≤x≤1, 0≤v≤1, 0≤z≤1). The active layer formed of the quantum barrier layers and the quantum well layers alternately stacked one above another can suppress spontaneous polarization due to stress and strain.

The p-type nitride layer 191 is placed under the active layer, and is made of a p-type dopant-doped nitride. The p-type dopant may include Mg, Zn, Cd, and the like. The p-type nitride layer may be a stack structure of first layers and second layers alternately stacked one above another. The first layer is formed of Mg-doped p-type AlGaN or undoped AlGaN, and the second layer is formed of undoped or Mg-doped p-type GaN. It should be understood that, although the p-type nitride layer may also be formed as a monolayer of n-type nitride, the stack structure of the first and second layers can act as a crack-free carrier-limiting layer having good crystallinity.

Fig. 4 is a sectional view taken along line B-B, illustrating electrical connection between the p-side spreading metal layer and the barrier metal layer. Referring to Fig. 4, the nitride semiconductor light emitting diode according to the present invention includes, from bottom to top, a lower substrate 160, a first junction metal layer 171, a bonding metal layer 170, a second junction metal layer 172, a second insulating layer 182, a p-side spreading metal layer 140, a first insulating layer 181, a barrier metal layer 122, a reflective metal layer 121, a p-type nitride layer 191, an active layer 192, and an n-type nitride layer 193. In addition, the diode includes, outside a light emitting face, a p-side electrode pad 141 electrically connected to the p-side spreading metal layer 140, a third insulating layer 183 placed above the p-side electrode pad 141, and a p-side pad metal 152 electrically connected to the p-side electrode pad 141 through the third insulating layer 183.

Since the p-side electrode pad 141 is formed at each corner of the light emitting diode, as shown in Fig. 2, the p-side electrode pad is placed in a region not overlapping the p-type nitride layer 191, the active layer 192, and the n-type nitride layer 193 in a vertical direction.

Unlike the light emitting diode shown in Fig. 3, the barrier metal layer 122 is partially exposed downwards through the first insulating layer 181, and the p-side spreading metal layer 140 is electrically connected to the reflective metal layer 121 through the exposed barrier metal layer 122. That is, the barrier metal layer 122 may be present between the p-side spreading metal layer 140 and the reflective metal layer 121.

Further, as described above, the first insulating layer 181 serves as an etching stopper to protect the electrode pad, when the n-type nitride layer, the active layer, and the p-type nitride layer are etched to expose the n-side electrode pad 141.

The bonding metal layer 170 or, in the case where the junction metal layer 172 is formed on the bonding metal layer 170, the junction metal layer 171 is electrically isolated from the p-side spreading metal layer 140 by the second insulating layer 182. To this end, the second insulating layer 182 is placed directly under the p-side spreading metal layer 140.

As a result, the first insulating layer 181 and the second insulating layer 182 form a stack structure together with a portion of the p-side spreading metal layer 140.

Further, as shown in Fig. 4, although the n-side spreading metal layer 130 may be formed in a region where the p-side spreading metal layer 140 is not formed, it will be apparent to those skilled in the art that the p-side spreading metal layer 140 and the n-side spreading metal layer 130 are separated from each other by the second insulating layer 182.

In addition, the third insulating layer 183 may be formed above the p-side electrode pad 141, and the p-side pad metal 152 may be electrically connected to the p-side electrode pad 141 through the third insulating layer 183.

The nitride semiconductor light emitting diode according to the present invention secures stable operation of the light emitting diode by allowing heat generated from semiconductor layers to be efficiently discharged through a lower substrate, thereby improving durability. In addition, the nitride semiconductor light emitting diode according to the invention has improved current spreading capabilities due to exposure of the first semiconductor layer, thereby providing improved brightness.

Although some exemplary embodiments have been described herein, it should be understood by those skilled in the art that these embodiments are given by way of illustration only, and that various modifications, variations and alterations can be made without departing from the spirit and scope of the invention. Therefore, the scope of the invention should be limited only by the accompanying claims and equivalents thereof.

## Claims

1. A semiconductor light emitting diode comprising: from bottom to top, a substrate; a bonding metal layer; a first spreading metal layer; a second spreading metal layer; a reflective metal layer; an insulating layer isolating the first spreading metal layer from the second spreading metal layer; a stack structure of a second semiconductor layer, an active layer and a first semiconductor layer, the stack structure being partially placed on the reflective metal layer; and first and second electrode pads formed in regions not overlapping the first semiconductor layer, the active layer, and the second semiconductor layer in a vertical direction.

2. The semiconductor light emitting diode according to claim 1, wherein the substrate is formed in a monolayer or multilayer structure of at least one compound selected from among AlN, SixNy, SiC, Si, GaAs, GaP, InP, ZnSe, ZnS, Al2O3, BeO, ZnO, CuW, CuMo, AlSiC, W, Mo, diamond, and metal silicide.

3. The semiconductor light emitting diode according to claim 1 or 2, wherein the reflective metal layer comprises at least one metal selected from among Ag, Ni, Al, Rh, Pd, Ir, Ru, Mg, Zn, Pt, and Au.

4. The semiconductor light emitting diode according to any one of claims 1 to 3, further comprising: a barrier metal layer between the second spreading metal layer and the reflective metal layer.

5. The semiconductor light emitting diode according to claim 4, wherein the barrier metal layer comprises at least one metal selected from among Ti, Cr, Ni, Pt, W, Ir, and Pd.

6. A semiconductor light emitting diode comprising, from top to bottom, a first semiconductor layer, an active layer, and a second semiconductor layer, the light emitting diode further comprising:
a lower substrate;
a bonding metal layer placed between the lower substrate and the second semiconductor layer;
a plurality of exposing portions formed by partially removing the second semiconductor layer and the active layer such that the first semiconductor layer is exposed therethrough;
a reflective metal layer formed in contact with the second semiconductor layer;
first and second electrode pads formed outside a light emitting face above the lower substrate;
a first spreading metal layer electrically connected to the exposing portions and the first electrode pad and formed on a rear side of the light emitting face;
a second spreading metal layer electrically connected to the reflective metal layer and the second electrode pad and formed on the rear side of the light emitting face; and
a first insulating layer forming a stack structure together with a portion of the first spreading metal layer or the second spreading metal layer, and electrically insulating the first spreading metal later from the active layer, the second semiconductor layer, the reflective metal layer and the second spreading metal layer.

7. The semiconductor light emitting diode according to claim 6, wherein the lower substrate is formed in a monolayer or multilayer structure of at least one compound selected from among AlN, SiₓN_{y}, SiC, Si, GaAs, GaP, InP, ZnSe, ZnS, Al₂O₃, BeO, ZnO, CuW, CuMo, AlSiC, W, Mo, diamond, and metal silicide.

8. The semiconductor light emitting diode according to claim 6 or 7, wherein the reflective metal layer comprises at least one metal selected from among Ag, Ni, Al, Rh, Pd, Ir, Ru, Mg, Zn, Pt, and Au.

9. The semiconductor light emitting diode according to any one of claims 6 to 8, further comprising: a barrier metal layer protecting the reflective metal layer.

10. The semiconductor light emitting diode according to claim 9, wherein the barrier metal layer comprises at least one metal selected from among Ti, Cr, Ni, Pt, W, Ir, and Pd.

11. The semiconductor light emitting diode according to claim 9 or 10, wherein the barrier metal layer is partially exposed through the first insulating layer, and the reflective metal layer is connected to the second spreading metal layer through the exposed barrier metal layer.

12. The semiconductor light emitting diode according to any one of claims 6 to 11, further comprising: a second insulating layer electrically isolating the bonding metal layer from the spreading metal layers.

13. The semiconductor light emitting diode according to claim 12, wherein the lower substrate is bonded to the second insulating layer.

14. The semiconductor light emitting diode according to any one of claims 6 to 13, wherein a junction metal layer(s) is or are formed on one or both sides of the bonding metal layer.

15. The semiconductor light emitting diode according to any one of claims 6 to 14, wherein the exposing portions are arranged in a regular matrix.
